# EUROPÄISCHE PATENTSCHRIFT

(11) **EP 1 204 992 B1**
(45) Veröffentlichungstag und Bekanntmachung des Hinweises auf die Patenterteilung: **13.09.2006**
(21) Anmeldenummer: 00945560.1
(22) Anmeldetag: 23.05.2000
(51) Int. Cl.: H01L 29/423, H01L 21/336, H01L 29/78

(54) **VERFAHREN ZUM HERSTELLEN EINES TRENCH-MOS-LEISTUNGSTRANSISTORS**
METHOD FOR PRODUCING A TRENCH MOS POWER TRANSISTOR
PROCEDE DE PRODUCTION D'UN TRANSISTOR DE PUISSANCE MOS A TRANCHEES

(30) Priorität: 28.07.1999 DE 19935442
(43) Veröffentlichungstag der Anmeldung: 15.05.2002
(73) Patentinhaber: Infineon Technologies AG, 81669 München (DE)
(72) Erfinder: LARIK, Joost, D-85586 Poing (DE); HIRLER, Franz, D-84424 Isen (DE); KOTEK, Manfred, A-9500 Villach (AT)
(74) Vertreter: Kottmann, Heinz Dieter
(86) Internationale Anmeldenummer: PCT/DE2000/001647
(87) Internationale Veröffentlichungsnummer: WO 2001/009956

(56) Entgegenhaltungen:
- EP-A- 0 899 791
- WO-A-97/07548
- US-A- 5 283 201
- US-A- 5 605 852
- US-A- 5 637 898
- US-A- 5 918 114

## Beschreibung

Die vorliegende Erfindung betrifft ein Verfahren zum Herstellen einer Trench-MOS-Leistungstransistors, bei dem in einen Halbleiterkörper wenigstens ein Graben eingebracht wird, der dann mit einem von der Grabeninnenfläche durch eine Isolierschicht getrennten leitenden Material wenigstens teilweise ausgefüllt wird, wobei die Isolierschicht so in den Graben eingebracht wird, daß diese im Bereich des unteren Endes des Grabens mit einer größeren Schichtdicke als an dessen oberem Ende versehen wird.

Für die Entwicklung von neuen Generationen von DMOS-Leistungstransistoren ist die Verringerung des spezifischen Einschaltwiderstandes von großer Bedeutung. Denn mit einer solchen Verringerung des spezifischen Einschaltwiderstandes ist es möglich, die statische Verlustleistung zu reduzieren und dabei höhere Stromdichten zu erreichen, so daß kleinere und billigere Chips für den gleichen Gesamtstrom eingesetzt werden können.

Aus diesem Grund wird schon seit längerem darüber nachgedacht, wie der spezifische Einschaltwiderstand in zweckmäßiger Weise vermindert werden kann. Grundsätzlich ist dies nun dadurch möglich, daß von einer planaren Zellenstruktur abgegangen wird und Trenchzellen verwendet werden. Durch den Einsatz von Trenchzellen kann nämlich der Kanalwiderstand eines MOS-Transistors durch eine deutliche Vergrößerung der Kanalweite pro Flächeneinheit vermindert werden. Der Widerstand der Driftstrecke, der auch als "Epiwiderstand" bezeichnet wird, da sich die Driftstrecke bevorzugt in einer auf einem Halbleitersubstrat aufgebrachten epitaktischen Schicht befindet, kann durch Verwendung von tiefen Trenches reduziert werden (vgl. hierzu US 4 941 026).

Tiefe Trenches setzen aber voraus, daß im unteren Bereich dieser Trenches eine dickere Isolierschicht, die hier auch als Feldplatte bezeichnet wird, als im oberen Bereich, d.h. im Kanalbereich, mit dem eigentlichen Gateoxid verwendet wird.

Bei der Entwicklung von Trench-MOS-Leistungstransistoren ist die Erreichung der erforderlichen Gateoxidqualität eine besondere Herausforderung. Einerseits muß das Gateoxid auf den verschiedensten Kristallorientierungen aufgewachsen werden, weil auch der Trenchboden und die an der Oberfläche des Halbleiterkörpers liegende Kante bzw. Ecke mit einer Isolierschicht, also dem Gateoxid überzogen werden muß. Da die Geschwindigkeit des Oxidwachstums von der Kristallorientierung abhängt, führt dies zu einer ungewollten Verbreiterung der Dickenverteilung des Gateoxides über den Trench. Die Oxidation von gekrümmten Siliziumflächen verursacht Dünnungen im Gateoxid und Spitzen im Silizium des Halbleiterkörpers. Dies wirkt sich wiederum negativ auf die elektrische Qualität des Gateoxides aus, weil die dünnste Stelle die Durchbruchsfeldstärke bestimmt. Jedoch muß das leitende Gatematerial, insbesondere dotiertes Polysilizium, an irgendeiner Stelle über die Kante herausgeführt werden um dieses elektrisch anzuschließen. Das Gateoxid ist an dieser Stelle besonders durchbruchsgefährdet.

Ein weiteres Ziel bei der Entwicklung von Trench-MOS-Leistungstransistoren ist es, die elektrischen Feldspitzen im Sperrfall so zu modulieren, daß die Lawinenmultiplikation im Halbleiterkörper und nicht an einer Grenzfläche eintritt. Der Avalanchedurchbruch an der Grenzfläche zwischen Halbleiterkörper und Gateoxid würde nämlich zur Injektion von heißen Ladungsträgern ins Gateoxid und somit einem Driften des Bauelementes führen.

Die bisherigen Verfahren zum Herstellen derartiger Trench-MOS-Leistungstransistorzellen, bei denen eine Isolierschicht im unteren Bereich des Trenchs dicker ist als im oberen Bereich, sind relativ aufwendig.

Ein Beispiel hierfür ist in der US 5 326 711 beschrieben: bei diesem bekannten Verfahren sind beispielsweise insgesamt drei Abscheidungen von polykristallinem Silizium im Herstellungsprozeß erforderlich, um den Trench in der gewünschten Weise zu gestalten.

Bei einem aus EP 0 666 590 A2 bzw. US 5 783 491 bekannten Verfahren wird die Qualität des Gatedielektrikums mittels zweimaliger Oxidation ("Sacrificial oxide") und Abätzung des Oxids verbessert. Damit wird eine gewisse Verrundung der Siliziumkanten erreicht.

Es ist daher Aufgabe der vorliegenden Erfindung, ein Verfahren zum Herstellen eines Trench-MOS-Leistungstransistors anzugeben, mit dem ein Trench mit dickerer Isolierschicht in einem unteren Bereich als in einem oberen Bereich auf einfache Weise herzustellen ist.

Diese Aufgabe wird bei einem Verfahren zum Herstellen eines Trench-MOS-Leitungstransistors, bei dem in einen Halbleiterkörper wenigstens ein Graben eingebracht wird, der dann mit einem von der Grabeninnenfläche durch eine Isolierschicht getrennten leitenden Material wenigstens teilweise ausgefüllt wird, wobei die Isolierschicht so in den Graben eingebracht wird, daß diese im Bereich des unteren Endes des Grabens mit einer größeren Schichtdicke als an dessen oberen Ende versehen wird, dadurch gelöst, daß
(a) in den Halbleiterkörper der wenigstens eine Graben eingebracht wird,
(b) die Wände und der Boden des Grabens mit einem ersten Isolierfilm belegt werden,
(c) das untere Ende des Grabens mit einer ersten Hilfsschicht gefüllt wird,
(d) die nicht mit der ersten Hilfsschicht belegten Teile des ersten Isolierfilms entfernt werden,
(e) die Hilfsschicht entfernt wird,
(f) ein zweiter Isolierfilm, der dünner als die Enddicke des ersten Isolierfilmes ist, auf den freiliegenden Wänden des Grabens aufgewachsen wird,
(g) der Graben mit dem leitenden Material gefüllt wird und (h) Source- und Bodyzonen in den Halbleiterkörper eingebracht und Metallisierungen zur Kontaktierung dieser Zonen angebracht werden.

Gemäß der Erfindung wird in Schritt (b) der erste Isolierfilm in mehreren thermisch oxidierten und abgeschiedenen Schichten aufgetragen.

Im Gegensatz dazu wird in dem aus US 5 283 201 bekannten Verfahren eine einzige, thermisch oxidierte Schicht gebildet.

Soll in bestimmten Bereichen die Entfernung des ersten Isolierfilmes verhindert werden, was am Rand der Fall sein kann, so wird in diesen Bereichen eine weitere Hilfsschicht als Maskierung aufgetragen. Auch kann von der angegebenen Reihenfolge abgewichen werden, indem beispielsweise die Source- und Bodyzonen zuerst erstellt weden.

Mit dem erfindungsgemäßen Verfahren wird eine Struktur vorgeschlagen, die sowohl die kritischen Stellen hinsichtlich Gateoxidqualität entschärft, als auch im aktiven Bereich eine Modulation der Feldverteilung mittels Trench-Feldplatte zuläßt. Im oberen Teil eines Trenches befindet sich die eigentliche MOS-Struktur des Transistors mit dem Gateoxid. Im unteren Teil des Trenches ist das Dielektrikum (Feldplatte) dikker als das Gateoxid. Dadurch kann über dem Dielektrikum eine höhere Spannung abfallen, was tiefere Trenches und einen niedrigeren Einschaltwiderstand Ron erlaubt. Der Übergang zwischen Gateoxid und Feldplattenoxid ist vorzugsweise graduiert. Ein abrupter Übergang würde zu ungünstigen Feldspitzen im Silizium führen. Die Trenches können sowohl in Zellen, Streifen als auch in beliebigen anderen geometrischen Formen angeordnet sein.

Im obigen Schritt (c) kann der Graben auch mit der ersten Hilfsschicht gefüllt und rückgeätzt werden, so daß die erste Hilfsschicht am unteren Ende des Grabens zurückbleibt.

Das Gatematerial wird über Dickoxid an die Oberfläche des Halbleiterkörpers geführt, was bedeutet, daß die elektrische Feldstärke im Oxid an kritischen Kanten entschärft ist.

Für den Halbleiterkörper kann in bevorzugter Weise ein hoch mit Bor dotiertes Siliziumsubstrat als Ausgangsmaterial verwendet werden, auf das eine p-leitende epitaktische Schicht mit einer Dotierstoffkonzentration von 1 x 10¹⁴ bis 1 x 10¹⁸ Ladungsträger cm⁻³ abgeschieden wird. Das Ätzen der Trenches kann dann in üblicher Weise mit Hilfe einer strukturierten Trenchmaske, die beispielsweise aus Siliziumdioxid besteht, vorgenommen werden. Nach dem Herstellen der Trenches wird diese Trenchmaske entfernt.

Die Trenches selbst können als Streifen oder auch als Gitter für eine Zellenstruktur ausgeführt werden. Die Weite der Trenches sollte dabei größer als die doppelte Breite eines später aufgetragenen ersten Isolierfilmes aus beispielsweise Siliziumdioxid (Feldoxid) sein.

Dieser erste Isolierfilm wird mit einer Schichtdicke aufgetragen, die von der Spannungsklasse abhängt, für die die Trench-MOS-Transistorzelle eingesetzt werden soll. Die Schichtdicken können dabei von Bereichen unterhalb 0,1 µm bis einige µm reichen. Sollen Stufen des Isolierfilmes an dessen späterem oberen Rand vermieden werden, so ist es zweckmäßig, für den ersten Isolierfilm ein Mehrschichtsystem einzusetzen, also den ersten Isolierfilm aus mehreren Schichten aus beispielsweise thermischem Siliziumdioxid durch thermische Oxidation des trenchgeätzten Halbleiterkörpers und einem abgeschiedenen Siliziumdioxid (TEOS), zu gestalten. Diese Materialien können alternativ auch für den ersten Isolierfilm verwendet werden, wenn dieser aus nur einer Schicht besteht.

Für die erste Hilfsschicht kann in vorteilhafter Weise beispielsweise Photolack eingesetzt werden, der zunächst bis über die Silizium-Kante des Halbleiterkörpers reicht und dann in den Trenches bis unter die sogenannte "Bodyunterkante", einer n-leitenden Wanne in der p-leitenden epitaktischen Schicht, rückgeätzt wird. Bei Verwendung von Photolack für die Hilfsschicht wird vorzugsweise eine Temperaturbehandlung ("postbake") vorgenommen.

Sollen inaktive Trenches erzeugt werden, so können die entsprechenden Bereiche des ersten Isolierfilmes mit einer weiteren Hilfsschicht maskiert werden. Für diese weitere Hilfsschicht kann beispielsweise Photolack verwendet werden.

Nach Auftragen der Hilfsschicht wird der erste Isolierfilm beispielsweise auf naßchemischem Wege isotrop geätzt, so daß dieser erste Isolierfilm lediglich unter der ersten Hilfsschicht zurückbleibt. Anschließend wird die erste Hilfsschicht entfernt. Sodann wird die Gate-Isolierschicht aus beispielsweise Siliziumdioxid, das sogenannte Gateoxid, aufgewachsen, dessen Schichtdicke abhängig von der beabsichtigten Einsatzspannung der Trench-MOS-Transistorzelle zwischen einigen wenigen nm bis über 100 nm beträgt. Wichtig ist aber, daß diese Gate-Isolierschicht, die den zweiten Isolierfilm bildet, dünner als die Enddicke des Isolierfilmes ist.

Die weitere Herstellung der Trench-MOS-Transistorzelle erfolgt, von einer Ausnahme abgesehen, in üblicher Weise:

Das Bodygebiet wird, maskiert durch den ersten Isolierfilm oder durch eine eigene Phototechnik, implantiert und ausdiffundiert. Sodann wird das Gatematerial, insbesondere polykristallines Silizium abgeschieden und dotiert. Nach einem strukturierten Zurückätzen des Gatematerials bis unter die Siliziumoberkante des Halbleiterkörpers kann gegebenenfalls eine Versiegelung des Gatematerials mit einer Isolierschicht aus Siliziumdioxid folgen, um eine Ausdiffusion von Dotierstoffen zu verhindern. Diese Reihenfolge von Diffusion des Bodygebietes und Strukturieren bzw. Versiegeln des Gatematerials könnte gegebenenfalls auch geändert, d.h. umgekehrt werden.

Es ist nun vorteilhaft, wenn eine sogenannte "Bodyverstärkung" eingebracht wird. Dies geschieht in bevorzugter Weise durch Implantation einer n⁺-leitenden Zone im n-leitenden Bodybereich, wenn das Halbleitersubstrat p-leitend ist. Selbstverständlich können die jeweiligen Leitungstypen auch umgekehrt sein. Diese Bodyverstärkung bewirkt eine Verminderung der Durchbruchsspannung der MOS-Transistorzelle an der Stufe zwischen dem ersten dickeren Isolierfilm und dem zweiten dünneren Isolierfilm, d.h. an der sogenannten Oxidstufe im Trench. Eine bevorzugte Dotierstoffkonzentration für die Bodyverstärkung beträgt etwa 1 x 10¹⁸ Ladungsträger cm⁻³.

Die Bodyverstärkung und weitere Dotierungen können auch zu einem anderen Zeitpunkt, beispielsweise am Anfang des Prozesses, eingebracht werden.

Es schließt sich sodann eine Implantation der Sourcezone an, wobei diese Implantation durch den ersten Isolierfilm oder eine eigene Phototechnik maskiert sein kann. Nach Abscheiden eines Dielektrikums aus beispielsweise Siliziumdioxid zur Isolation von Gate und Sourcemetallisierung wird ein Ätzen der Kontaktlöcher vorgenommen.

Nach einer maskierten Implantation eines n⁺⁺-leitenden Bodykontaktes, die gegebenenfalls für jede Trench-MOS-Transistorzelle vorgenommen wird, folgt die übliche Metallabscheidung mit beispielsweise Aluminium für die Sourcezone und den Bodykontakt. Die durch die Metallabscheidung aufgetragene Metallisierung wird sodann strukturiert, worauf noch eine Passivierung folgen kann. Zusammenfassend ermöglicht die Erfindung insbesondere die folgenden Vorteile:
- gute Gateoxidqualität durch Entschärfung von Kanten und Ekken; es wird an keiner Stelle des Transistors Gatematerial über Gateoxid an kritischen Kanten geführt;
- dickes Oxid des ersten Isolierfilmes im Boden des Trenches um hohen Drain-Gate-Spannungen standzuhalten;
- abgestufter Übergang von erstem und zweitem Isolierfilm entlang eines Trenches für hohe Spannungen am Rand; und
- Feldplattenwirkung durch den tiefen Trench zur Verringerung des Ron-Anteiles der Body- bzw. Driftzone.

Nachfolgend wird die Erfindung anhand der Zeichnung näher erläutert. Es zeigen:
- Fig. 1 bis 7: verschiedene Schnitte, die den Ablauf des erfindungsgemäßen Verfahrens nach einem ersten Ausführungsbeispiel veranschaulichen,
- Fig. 8 bis 10: verschiedene Schnitte, die den Ablauf des erfindungsgemäßen Verfahrens nach einem zweiten Ausführungsbeispiel veranschaulichen,
- Fig. 11 und 12: zwei verschiedene Schnitte, die den Ablauf des erfindungsgemäßen Verfahrens nach einem dritten Ausführungsbeispiel veranschaulichen,
- Fig. 13 und 14: verschiedene Schnitte, die den Ablauf des erfindungsgemäßen Verfahrens nach einem vierten Ausführungsbeispiel veranschaulichen, und
- Fig. 15 bis 17: verschiedene Schnitte, die den Ablauf des erfindungsgemäßen Verfahrens nach einem fünften Ausführungsbeispiel veranschaulichen.

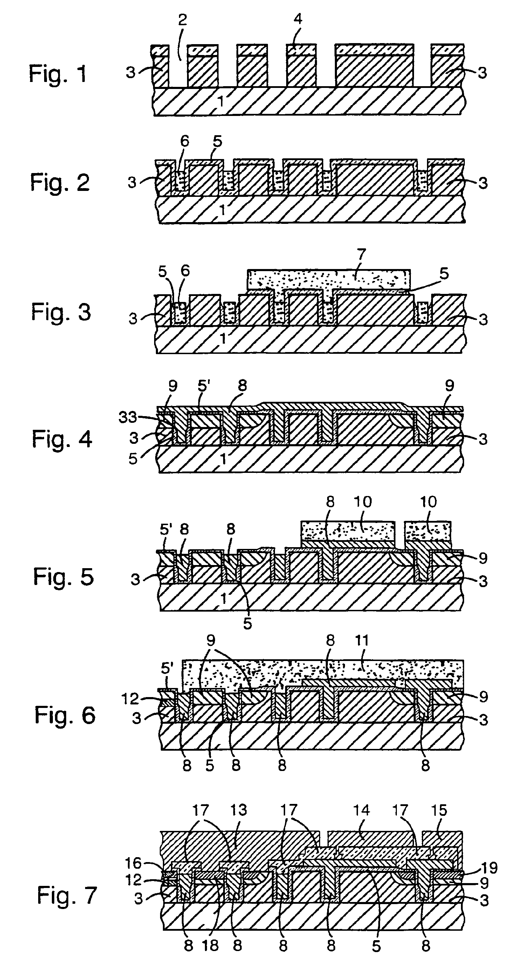

Fig. 1 zeigt ein p⁺-leitendes Siliziumsubstrat 1, auf das epitaktisch eine p-leitende Siliziumschicht 3 aufgetragen wird, in die mit Hilfe einer Siliziumdioxidschicht 4 oder einem anderen geeigneten Material als Maske Gräben 2 eingeätzt werden, die im wesentlichen bis zu dem Siliziumsubstrat 1 reichen und in dieses eindringen können. Jedoch sind auch geringere Tiefen der Gräben 2 möglich.

Es kann auch gegebenenfalls ein Opferoxid (sacrificial oxide) zur Erhöhung der Grenzflächenbeweglichkeit aufgebracht und dann wieder entfernt werden.

Das Siliziumsubstrat 1 und die Schicht 3 können beide mit Bor dotiert sein, wobei die Dotierstoffkonzentration in der Schicht 3 etwa 1 x 10¹⁴ bis 1 x 10¹⁸ Ladungsträger cm⁻³ beträgt.

Nach Ätzen der Gräben 2 wird die als Trenchmaske dienende Siliziumdioxidschicht 4 entfernt.

Sodann wird ein erster Siliziumdioxidfilm 5 als Feldoxid mit einer Schichtdicke abgeschieden, die von der angestrebten Spannungsklasse für die MOS-Transistorzelle abhängt, wie dies oben erläutert wurde. Bevorzugte Schichtdicken liegen zwischen 0,1 µm bis einigen µm. Zur Vermeidung von Oxidstufen (vgl. oben) und zur Erzeugung von flach ansteigenden Oxidkanten werden für das Feldoxid mehrere Schichten aus beispielsweise thermisch oxidiertem Siliziumdioxid durch Oxidation des trenchgeätzten Halbleiterkörpers und abgeschiedenem Siliziumdioxid (TEOS bzw. LPCVD-Oxid) vorgesehen

Die gewünschte Anschrägung des Oxides bzw. der graduierte Übergang von Gateoxid auf Feldplattenoxid ergibt sich durch die höhere naßchemische Ätzrate des LPCVD-Oxides gegenüber dem thermischen Oxid. Die Dicke der beiden Schichten wird so gewählt, daß das Oxid im Trenchboden den Spannungsanforderungen des Transistors standhält.

Sodann wird eine Hilfsschicht 6 aus beispielsweise Photolack bis über die Kante des Halbleiterkörpers aufgetragen, gehärtet und rückgeätzt, so daß in den Gräben 2 nur "Stöpsel" unter der Bodyunterkante zurückbleiben. Bei Verwendung von Photolack für die Hilfsschicht 6 schließt sich eine Temperaturbehandlung ("postbake") an. Damit wird die in Fig. 2 gezeigte Struktur erhalten.

Für beispielsweise eine Randkonstruktion kann sodann eine zusätzliche Maskierung mittels einer weiteren Hilfsschicht 7 aus Photolack, der belichtet und entwickelt wird, vorgenommen werden, wodurch bei einer anschließenden Rückätzung das Feldoxid 5 unterhalb dieser weiteren Hilfsschicht 7 zurückbleibt.

Es schließt sich sodann eine isotrope, naßchemische Ätzung des Feldoxids 5 an, so daß dieses in den von der weiteren Hilfsschicht 7 freiliegenden Bereichen nur unterhalb der Hilfsschicht 6 zurückbleibt. Damit wird die in Fig. 3 gezeigte Struktur erhalten.

Die beiden Trenches unterhalb der Hilfsschicht 7 sind sogenannte "inaktive" Trenches im Gegensatz zu den übrigen, "aktiven" Trenches. Die inaktiven Trenches dienen beispielsweise zum elektrischen Anschließen der Gates, als Gatefinger und - wie bereits erwähnt - für die Randkonstruktion.

Es werden sodann die beiden Hilfsschichten 6 und 7 entfernt, d.h., der Photolack wird abgetragen.

Anschließend wird ein Gate-Isolierfilm 5' aus Siliziumdioxid aufgewachsen, der dünner als der erste Isolierfilm 5 ist, so daß in den Gräben 2 eine Stufe ("Oxidstufe") 33 entsteht.

Diese Stufe 33 kann abgeschrägt sein, wenn für den ersten Isolierfilm 5 mehrere Schichten verwendet werden, wie dies oben erläutert wurde. Der Winkel der abgeschrägten Stufe 20 zur Senkrechten kann beispielsweise 17° betragen. Selbstverständlich sind aber auch andere Winkel möglich.

Die Gate-Isolierschicht 5' wird abhängig von der beabsichtigten Einsatzspannung der Trench-MOS-Transistorzelle mit einer Schichtdicke von einigen wenigen nm bis über 100 nm versehen. Jedenfalls ist aber die Schichtdicke der Gate-Isolierschicht 5' geringer als die Enddicke des ersten Isolierfilmes 5.

Es schließt sich sodann eine Implantation und Ausdiffusion eines n-leitenden Bodygebietes 9 an, wobei diese Implantation durch das Feldoxid 5 bzw. 5' oder durch eine eigene Phototechnik maskiert sein kann. Sodann wird Gatematerial 8 aus beispielsweise polykristallinem Silizium abgeschieden und dotiert, wodurch die in Fig. 4 gezeigte Struktur erhalten wird.

Das Gatematerial 8 wird sodann mit Hilfe einer Maskierungsschicht 10 aus beispielsweise Photolack strukturiert bis unter die Siliziumoberkante rückgeätzt, so daß die in Fig. 5 dargestellte Struktur entsteht.

Nach Entfernen der Maskierungsschicht 10 kann eine Versiegelung des polykristallinen Materials 8 mit Hilfe beispielsweise einer in den Zeichnungen nicht gezeigten dünnen Siliziumdioxidschicht vorgenommen werden, um eine Ausdiffusion von Dotierstoffen aus dem polykristallinen Material 8 zu verhindern. Es schließen sich sodann das Auftragen einer Fotolackschicht 11 mit unkritischer Flanke über dem in Fig. 6 linken polykristallinen Material 8 sowie eine Implantation und gegebenenfalls ein Ausheilen einer n⁺-leitenden Bodyverstärkungszone 12 im Bereich der Oxidstufe 33 an, um die Durchbruchsspannung der Trench-MOS-Transistorzelle unter die Durchbruchsspannung an der Oxidstufe 33 im Graben 2 zu senken. Die Dotierstoffkonzentration in dieser Zone 12 beträgt vorzugsweise etwa 1 x 10¹⁸ Ladungsträger cm⁻³. Damit liegt die in Fig. 6 gezeigte Struktur vor.

Schließlich werden, maskiert durch das Feldoxid oder durch eine eigene Phototechnik, noch eine p⁺⁺-leitende Sourcezone 18 und eine p⁺⁺-leitende Diffusionszone 19 eingebracht. Sodann wird eine Isolierschicht 17 aus Borphosphorsilikatglas aufgetragen, verdichtet und durch Ätzen von Kontaktlöchern strukturiert. Nach maskiertem Implantieren einer n⁺⁺-leitenden Bodykontaktzone 16 werden eine Metallisierung (Elektrode) 13 für Source, eine Metallisierung (Elektrode) 14 für Gate und eine Metallisierung 15 abgeschieden und strukturiert, wodurch nach einer Passivierung schließlich die in Fig. 7 gezeigte Struktur erhalten wird.

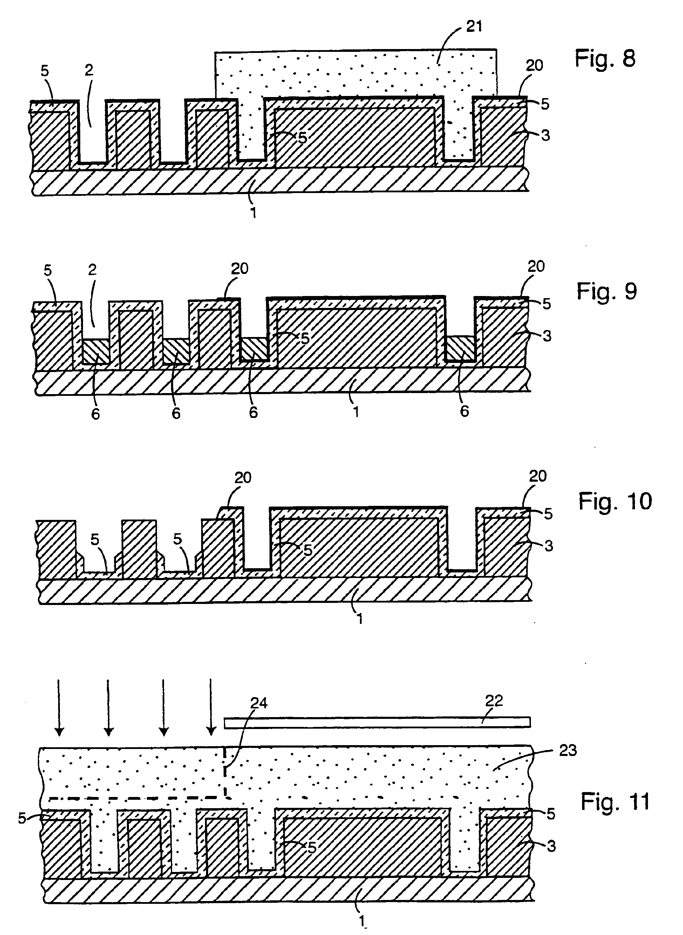

Die Fig. 8 bis 10 zeigen eine Variante des erfindungsgemäßen Verfahrens, bei der nach Auftragen des ersten Isolierfilmes 5 und vor Anbringen der Hilfsschicht 6 eine dünne Siliziumnitridschicht mit einer Schichtdicke von beispielsweise 20 nm auf dem Isolierfilm 5 aufgetragen (vgl. Fig. 8) und mit Hilfe einer Lackschicht 21 strukturiert wird, so daß die Siliziumnitridschicht 20 lediglich in den Bereichen unterhalb der Lackschicht 21 zurückbleibt. Damit wird erreicht, daß die Siliziumnitridschicht 20 lediglich im Bereich der inaktiven Trenches zurückbleibt. Nach einem Belacken und Rückätzen wird die in Fig. 9 gezeigte Anordnung erhalten, bei der die Hilfsschicht 6 aus Lackstöpseln in den Trenches verbleibt.

Bei einer nachfolgenden naßchemischen Siliziumoxidätzung wird der Isolierfilm 5 aus Siliziumdioxid in den Trenchböden der aktiven Trenches durch die Hilfsschicht 6 und die gesamten inaktiven Trenches mittels der Siliziumnitridschicht 20 maskiert. Nach Entfernen der Siliziumnitridschicht 20 und der Hilfsschicht 6 ist das Prozeßergebnis das gleiche wie bei dem ersten Ausführungsbeispiel vor Anbringen des zweiten Isolierfilmes 5'.

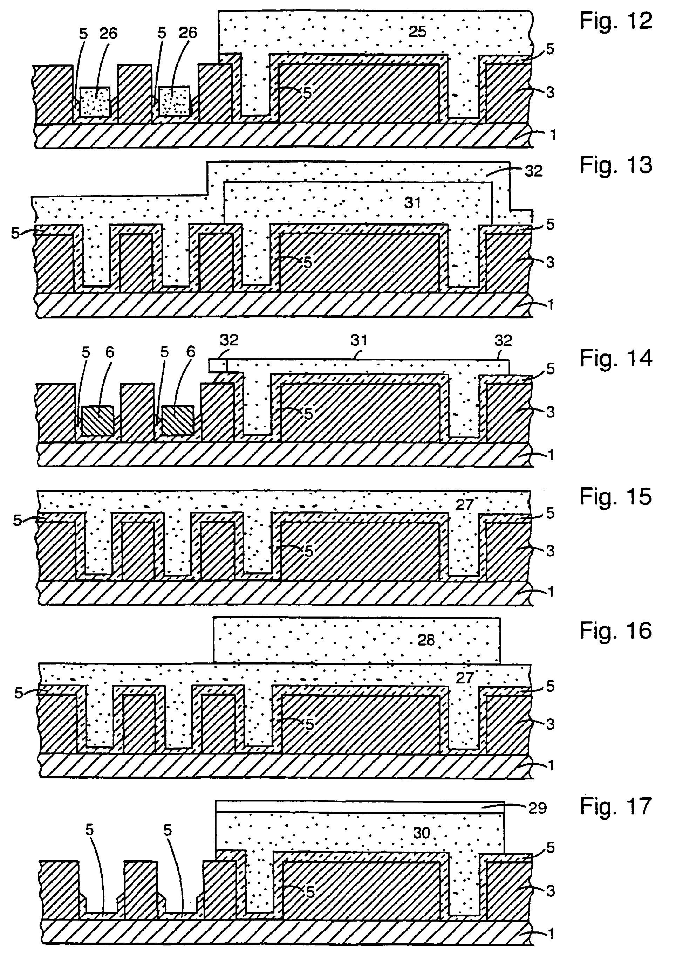

Die Fig. 11 und 12 veranschaulichen ein drittes Ausführungsbeispiel des erfindungsgemäßen Verfahrens, bei dem die Strukturierung des ersten Isolierfilmes 5 in den aktiven Trenches und den inaktiven Trenches mittels einer einzigen Phototechnik vorgenommen wird. Hier wird eine Lackschicht 23 mit einer Schichtdicke von beispielsweise 4 µm mittels einer Maske 22 nur bis in eine bestimmte Tiefe (vgl. die Strichlinie 24) belichtet. Der belichtete Teil der Lackschicht 23 wird entfernt. Nach einem weiteren Abtragen des Oberflächenbereiches der Lackschicht 23 verbleiben lediglich Lackstöpsel 26 als Hilfsschicht 6 und eine Lackschicht 25 mit einer Schichtdicke von etwa 1,5 µm über den inaktiven Trenches zurück. Dieser weitere Abtragungsprozeß der Lackschicht 23 zur Gewinnung der Lackstöpsel 26 und der Lackschicht 25 kann beispielsweise durch eine Plasmarückätzung erfolgen (vgl. Fig. 12). Anstelle einer solchen Plasmarückätzung kann gegebenenfalls auch eine Trockenentwicklung vorgenommen werden.

Die Fig. 13 und 14 zeigen Schnitte zur Veranschaulichung einer weiteren Variante des erfindungsgemäßen Verfahrens gemäß einem vierten Ausführungsbeispiel. Bei diesem Ausführungsbeispiel werden mittels einer ersten Photolackschicht 31 inaktive Trenches abgedeckt, während mit Hilfe einer zweiten Photolackschicht 32 die notwendige Topographie, d.h. Strukturierung des ersten Isolierfilmes 5 vorgenommen wird. Damit wird eine Anordnung erhalten, bei der die Hilfsschicht 6 in der Form von Lackstöpseln in den aktiven Trenches verbleibt, während die inaktiven Trenches mit der Photolackschicht 31 gefüllt sind. Nach Entfernen der Hilfsschicht 6 und der Reste der Photolackschichten 31 und 32 erfolgt die Weiterverarbeitung wie in dem ersten Ausführungsbeispiel.

Die Fig. 15 bis 17 zeigen schließlich Schnitte zur Erläuterung einer weiteren Variante des erfindungsgemäßen Verfahrens in einem fünften Ausführungsbeispiel, das zu dem vierten Ausführungsbeispiel ähnlich ist: auch hier werden zwei Phototechniken verwendet, jedoch wird hier eine strukturierende Photolackschicht 28 mit einer Schichtdicke von etwa 3 µm erst nach Auftragen einer Photolackschicht 27 mit einer Schichtdicke von etwa 1 µm erzeugt. Die so erhaltene Struktur ist in Fig. 16 gezeigt. Nach Entfernen von wesentlichen Teilen der Photolackschicht 28 und der Photolackschicht 27 verbleiben lediglich Photolackschichten 29 (als Rest der Photolackschicht 28) und 30 (als Rest der Photolackschicht 27), so daß die in Fig. 17 gezeigte Anordnung vorliegt. Dieses Entfernen von wesentlichen Teilen der Photolackschichten 27 und 28 kann wieder durch Plasmarückätzung oder Trockenentwicklung erfolgen. Schließlich werden die verbleibenden Teile 29 und 30 der Photolackschichten 28 und 27 abgetragen, um die dann erhaltene Anordnung in der gleichen Weise wie beim ersten Ausführungsbeispiel weiterzuverarbeiten.

## Patentansprüche

1. Verfahren zum Herstellen eines Trench-MOS-Leistungstransistors, bei dem in einen Halbleiterkörper (1, 3) wenigstens ein Graben (2) eingebracht wird, der dann mit einem von der Grabeninnenfläche durch eine Isolierschicht (5, 5') getrennten leitenden Material (8) wenigstens teilweise ausgefüllt wird, wobei die Isolierschicht (5, 5') so in den Graben (2) eingebracht wird, dass diese im Bereich des unteren Endes des Grabens (2) mit einer größeren Schichtdicke als an dessen oberen Ende versehen wird, umfassend die folgenden Schritte:
(a) in den Halbleiterkörper (1, 3) wird der wenigstens eine Graben (2) eingebracht,
(b) die Wände und der Boden des Grabens werden mit einem ersten Isolierfilm (5) belegt,
(c) das untere Ende des Grabens (2) wird mit einer ersten Hilfsschicht (6) gefüllt,
(d) die nicht mit der ersten Hilfsschicht (6) belegten Teile des ersten Isolierfilms (5) werden entfernt,
(e) die Hilfsschicht (6) wird entfernt,
(f) ein zweiter Isolierfilm (5'), der dünner als die Enddicke des ersten Isolierfilmes (5) ist, wird auf den freiliegenden Wänden des Grabens (2) aufgewachsen,
(g) der Graben wird mit dem leitenden Material (8) gefüllt und
(h) Source- und Bodyzonen (19) werden in den Halbleiterkörper (1, 3) eingebracht ,und Metallisierungen (13, 14, 15) werden zur Kontaktierung angebracht,
**dadurch gekennzeichnet , dass**
(b1) in Schritt (b) der erste Isolierfilm (5) in mehreren thermisch oxidierten und abgeschiedenen Schichten aufgetragen wird.

2. Verfahren nach Anspruch 1,
**dadurch gekennzeichnet , dass**
der Graben (2) in eine auf einem Halbleitersubstrat (1) vorgesehene epitaktische Schicht (3) eingebracht wird.

3. Verfahren nach Anspruch 1 oder 2,
**dadurch gekennzeichnet , dass**
die epitaktische Schicht (3) mit einer Dotierstoffkonzentration von 1 x 10¹⁴ bis 1 x 10¹⁸ Ladungsträger cm⁻³ versehen wird.

4. Verfahren nach einem der Ansprüche 1 bis 3,
**dadurch gekennzeichnet , dass**
die Gräben (2) streifen- oder gitterförmig in den Halbleiterkörper (1, 3) eingebracht werden.

5. Verfahren nach einem der Ansprüche 1 bis 4,
**dadurch gekennzeichnet , dass**
der erste Isolierfilm (5) mit einer Schichtdicke von etwa 0,1 µm bis einigen µm aufgetragen wird.

6. Verfahren nach einem der Ansprüche 1 bis 5,
**dadurch gekennzeichnet , dass**
für die erste Hilfsschicht (6) ein Fotolack verwendet wird.

7. Verfahren nach einem der Ansprüche 1 bis 6,
**dadurch gekennzeichnet , dass**
für eine Randkonstruktion als zusätzliche Maskierung eine weitere Hilfsschicht (7) aufgetragen wird, welche die Entfernung des ersten Isolierfilmes (5) in den maskierten Bereichen verhindert.

8. Verfahren nach einem der Ansprüche 1 bis 7,
**dadurch gekennzeichnet , dass**
der zweite Isolierfilm mit einer Schichtdicke von einigen nm bis über 100 nm aufgetragen wird.

9. Verfahren nach einem der Ansprüche 1 bis 8,
**dadurch gekennzeichnet , dass**
in ein Bodygebiet (9) eine Verstärkung (12) eingebracht wird.

10. Verfahren nach Anspruch 9,
**dadurch gekennzeichnet , dass**
die Verstärkung (12) implantiert wird.

11. Verfahren nach einem der Ansprüche 1 bis 10,
**dadurch gekennzeichnet , dass**
nach Belegen der Wände und des Bodens des Grabens mit dem ersten Isolierfilm (5) eine Siliziumnitridschicht (20) auf dem ersten Isolierfilm (5) aufgetragen und strukturiert wird.

12. Verfahren nach Anspruch 11,
**dadurch gekennzeichnet , dass**
die Siliziumnitridschicht (20) mit einer Schichtdicke von etwa 20 nm versehen wird.

13. Verfahren nach einem der Ansprüche 1 bis 10,
**dadurch gekennzeichnet , dass**
die Hilfsschicht (6 bzw. 26) und Strukturierung des ersten Isolierfilmes (5) mit Hilfe einer einzigen Photolackschicht (23), die über eine Maske (22) nur bis in eine vorgegebene Tiefe (24) belichtet wird, vorgenommen wird.

14. Verfahren nach einem der Ansprüche 1 bis 10,
**dadurch gekennzeichnet , dass** inaktive Gräben mittels einer in diese eingebrachten ersten Fotolackschicht (31) abgedeckt werden und eine Strukturierung des ersten Isolierfilmes (5) mittels einer zweiten, außerhalb der ersten Fotolackschicht (31) aufgetragenen Fotolackschicht (32) vorgenommen wird.

15. Verfahren nach Anspruch 13,
**dadurch gekennzeichnet , dass**
die strukturierende Fotolackschicht (32) nach der abdekkenden Fotolackschicht (31) aufgetragen wird.

## Claims

1. Method for fabricating a trench MOS power transistor, in which at least one trench (2) is introduced into a semiconductor body (1, 3), which trench is then at least partly filled with a conductive material (8) which is isolated from the inner area of the trench by an insulating layer (5, 5'), the insulating layer (5, 5') being introduced into the trench (2) in such a way that it is provided with a larger layer thickness in the region of the lower end of the trench (2) than at the upper end thereof, comprising the following steps:
(a) the at least one trench (2) is introduced into the semiconductor body (1, 3),
(b) the walls and the bottom of the trench are coated with a first insulating film (5),
(c) the lower end of the trench (2) is filled with a first auxiliary layer (6),
(d) those parts of the first insulating film (5) which are not coated with the first auxiliary layer (6) are removed,
(e) the auxiliary layer (6) is removed,
(f) a second insulating film (5'), which is thinner than the end thickness of the first insulating film (5), is grown on the uncovered walls of the trench (2),
(g) the trench is filled with the conductive material (8), and
(h) source and body zones (19) are introduced into the semiconductor body (1, 3), and metallization layers (13, 14, 15) are provided for contact connection,
**characterized in that**
(b1) in step (b), the first insulating film (5) is applied in a plurality of thermally oxidized and deposited layers.

2. Method according to Claim 1,
**characterized in that**
the trench (2) is introduced into an epitaxial layer (3) provided on a semiconductor substrate (1).

3. Method according to Claim 1 or 2,
**characterized in that**
the epitaxial layer (3) is provided with a dopant concentration of 1 x 10¹⁴ to 1 x 10¹⁸ charge carriers cm⁻³.

4. Method according to one of Claims 1 to 3,
**characterized in that**
the trenches (2) are introduced into the semiconductor body (1, 3) in strip or lattice form.

5. Method according to one of Claims 1 to 4,
**characterized in that**
the first insulating film (5) is applied with a layer thickness of about 0.1 µm to a few µm.

6. Method according to one of Claims 1 to 5,
**characterized in that**
a photoresist is used for the first auxiliary layer (6).

7. Method according to one of Claims 1 to 6,
**characterized in that**,
for an edge construction, as additional masking, a further auxiliary layer (7) is applied which prevents the removal of the first insulating film (5) in the masked regions.

8. Method according to one of Claims 1 to 7,
**characterized in that**
the second insulating film is applied with a layer thickness of a few nm to in excess of 100 nm.

9. Method according to one of Claims 1 to 8,
**characterized in that**
a reinforcement (12) is introduced into a body region (9).

10. Method according to Claim 9,
**characterized in that**
the reinforcement (12) is implanted.

11. Method according to one of Claims 1 to 10,
**characterized in that**,
after the walls and the bottom of the trench have been coated with the first insulating film (5), a silicon nitride layer (20) is applied on the first insulating film (5) and patterned.

12. Method according to Claim 11,
**characterized in that**
the silicon nitride layer (20) is provided with a layer thickness of about 20 nm.

13. Method according to one of Claims 1 to 10,
**characterized in that**
the auxiliary layer (6 or 26) and patterning of the first insulating film (5) is performed with the aid of a single photoresist layer (23), which is exposed via a mask (22) only down to a predetermined depth (24).

14. Method according to one of Claims 1 to 10,
**characterized in that**
inactive trenches are covered by means of a first photoresist layer (31) introduced therein and patterning of the first insulating film (5) is performed by means of a second photoresist (32), which is applied outside the first photoresist layer (31).

15. Method according to Claim 13,
**characterized in that**
the patterning photoresist layer (32) is applied after the covering photoresist layer (31).

## Revendications

1. Procédé de production d'un transistor de puissance MOS-Trench, dans lequel on ménage, dans un corps (1, 3) semi-conducteur, au moins un sillon (2) que l'on emplit ensuite, au moins en partie, d'une matière (8) conductrice séparée de la surface intérieure du sillon par une couche (5, 5') isolante, la couche (5, 5') isolante étant introduite dans les sillons (2) de façon à ce que qu'elle ait, dans la partie de l'extrémité inférieure du sillon (2), une épaisseur de couche plus grande que dans sa partie supérieure, comprenant les stades suivants :
(a) on ménage le au moins un sillon (2) dans le corps (1, 3) semi-conducteur,
(b) on met une première pellicule (5) isolante sur les parois et sur le fond du sillon,
(c) on emplit l'extrémité inférieure du sillon (2) d'une première couche (6) auxiliaire,
(d) on élimine les parties de la première pellicule (5) isolante, qui ne sont pas revêtues de la première couche (6) auxiliaire,
(e) on élimine la couche (6) auxiliaire,
(f) on fait croître, sur les parois mises à nu du sillon (2), une deuxième pellicule (5') isolante qui est plus mince que l'épaisseur finale de la première pellicule (5) isolante,
(g) on emplit le sillon de la matière (8) conductrice et
(h) on ménage des zones (19) de source et de body dans le corps (1, 3) semi-conducteur et on ménage des métallisations (13, 14, 15) pour la mise en contact,
**caractérisé en ce que**
(b1) dans le stade (b), on dépose la première pellicule (5) isolante en plusieurs couches oxydées thermiquement et déposées.

2. Procédé suivant la revendication 1,
**caractérisé en ce que** l'on ménage le sillon (2) dans une couche (3) épitaxiale prévue sur un substrat (1) semi-conducteur.

3. Procédé suivant la revendication 1 ou 2,
**caractérisé en ce que** l'on munit la couche (3) épitaxiale d'une concentration de substance de dopage de 1 x 10¹⁴ à 1 x 10¹⁸ porteurs de charge cm⁻³.

4. Procédé suivant l'une des revendications 1 à 3,
**caractérisé en ce qu'**on ménage les sillons (2) sous forme de bandes ou de réseau dans le corps (1, 3) semi-conducteur.

5. Procédé suivant l'une des revendications 1 à 4,
**caractérisé en ce que** l'on dépose la première pellicule (5) isolante en une épaisseur d'environ 0,1 µm à quelques µm.

6. Procédé suivant l'une des revendications 1 à 5,
**caractérisé en ce que** l'on utilise un vernis photosensible pour la première couche (6) auxiliaire.

7. Procédé suivant l'une des revendications 1 à 6,
**caractérisé en ce que** l'on dépose, pour une construction de bord en tant que masquage supplémentaire, une autre couche (7) auxiliaire qui empêche l'élimination de la première pellicule (5) isolante dans les parties masquées.

8. Procédé suivant l'une des revendications 1 à 7,
**caractérisé en ce que** l'on dépose la deuxième pellicule isolante en une épaisseur de quelques nm à plus de 100 nm.

9. Procédé suivant l'une des revendications 1 à 8,
**caractérisé en ce que** l'on ménage dans la zone (9) de body un renfort (12).

10. Procédé suivant la revendication 9,
**caractérisé en ce que** l'on implante le renfort (12).

11. Procédé suivant l'une des revendications 1 à 10,
**caractérisé en ce qu'**après avoir revêtu les parois et le fond du sillon de la première pellicule (5) isolante, on dépose et on structure une couche (20) de nitrure de silicium sur la première pellicule (5) isolante.

12. Procédé suivant la revendication 11,
**caractérisé en ce que** la couche (20) de nitrure de silicium a une épaisseur d'environ 20 nm.

13. Procédé suivant l'une des revendications 1 à 10,
**caractérisé en ce que** l'on produit la couche (6 ou 26) auxiliaire et la structuration de la première pellicule (5) isolante à l'aide d'une couche (23) unique de vernis photosensible qui n'est insolée par l'intermédiaire d'un masque (22) que jusqu'à une profondeur (24) prescrite.

14. Procédé suivant l'une des revendications 1 à 10,
**caractérisé en ce que** l'on revêt des sillons inactifs au moyen d'une première couche (31) de vernis photosensible qui y est introduite et on effectue une structuration de la première pellicule (5) isolante au moyen d'une deuxième couche (32) de vernis photosensible disposée à l'extérieur de la première couche (31) de vernis photosensible.

15. Procédé suivant la revendication 13,
**caractérisé en ce que** l'on déposé la couche (32) structurante de vernis photosensible après la couche (31) recouvrante de vernis photosensible.
